# EUROPÄISCHE PATENTANMELDUNG

(11) **EP 3 839 712 A1**
(43) Veröffentlichungstag der Anmeldung: **23.06.2021**
(21) Anmeldenummer: 20205756.8
(22) Anmeldetag: 04.11.2020
(51) Int. Cl.: G06F 3/044

(54) **ELEKTRODENARRAY FÜR FUNKTIONELLE OBERFLÄCHEN UND VERFAHREN ZUM HERSTELLEN EINES ELEKTRODENARRAYS**

(30) Priorität: 18.12.2019 DE 102019219938
(71) Anmelder: Robert Bosch GmbH, 70442 Stuttgart (DE)
(72) Erfinder: Scheiner, Philipp, 71263 Weil Der Stadt (DE)

(57) **Zusammenfassung**

Die Erfindung betrifft ein Elektrodenarray für funktionelle Oberflächen, insbesondere für Textilien, aufweisend eine erste Schicht und eine zweite Schicht, wobei die erste Schicht wenigstens eine Elektrodenfläche umfasst und wobei die zweite Schicht wenigstens ein Kontakt-Pads umfasst, wobei die zweite Schicht unterhalb der ersten Schicht derart angeordnet ist, dass die Elektrodenfläche das Kontakt-Pads, insbesondere vollständig, überdeckt und wobei das Kontakt-Pads die Elektrodenfläche mittels einer Durchkontaktierung elektrisch kontaktiert.

## Beschreibung

Die Erfindung geht aus von einem Elektrodenarray für funktionelle Oberflächen, insbesondere für Textilien, und einem Verfahren zum Herstellen eines Elektrodenarrays nach Gattung der unabhängigen Ansprüche.

### Stand der Technik

Aus der DE 10 2014 211 239 A1 ist eine flexible Folie aus polymerem Material, vorzugsweise mit einer Narbung oder Prägung versehenen Kunststofffolie, welche funktionale Flächenbereiche ausweist, bekannt.

### Offenbarung der Erfindung

Vor diesem Hintergrund wird mit dem hier vorgestellten Ansatz ein Elektrodenarray für funktionelle Oberflächen, insbesondere für Textilien, vorgestellt. Das Elektrodenarray weist hierbei eine erste Schicht und eine zweite Schicht auf. Hierbei umfasst die erste Schicht wenigstens eine Elektrodenfläche und die zweite Schicht umfasst wenigstens ein Kontakt-Pad. Ferner ist die zweite Schicht unterhalb der ersten Schicht derart angeordnet, dass die Elektrodenfläche das Kontakt-Pad, insbesondere vollständig, überdeckt und das Kontakt-Pad die Elektrodenfläche mittels einer Durchkontaktierung elektrisch kontaktiert.

Unter einem Elektrodenarray kann eine, insbesondere spezielle, Anordnung von Elektroden verstanden werden. Vorzugsweise kann darunter eine Mehrzahl an Elektroden verstanden werden, welche gleichmäßig, insbesondere in einer zeilen- und/oder spaltenartigen Form, angeordnet sind. Unter einer funktionellen bzw. funktionalisierten Oberfläche kann insbesondere verstanden werden, dass die Oberfläche für bestimmte technische Funktionen ausgebildet ist. im Falle eines funktionellen Textils kann bspw. vorgesehen sein, dass Metalle, Halbleiter oder dergleichen in das Textil eingearbeitet sind oder auf das Textil aufgebracht sind. Bspw. können elektrische Leiterbahnen als metallische Fäden und/oder metallisierte oder andersartig elektrisch leitfähig bzw. funktionell ausgerüstete Garne in das Textil eingearbeitet oder als elektrisch leitfähige Pasten auf das Textil aufgedruckt sein. Zusätzlich zu solchen funktionellen Materialien, die als Leiterbahnen, Elektroden oder Sensorelementen (z.B. temperatur-/feuchtesensitive Garne) eingebracht werden können, kann unter einer funktionellen Oberfläche auch eine Oberfläche verstanden werden, in die konventionelle elektronische Elemente oder Bauteile (Sensorik, Aktorik, etc.) eingebracht sind.

Unter einer Elektrode können Bereiche auf der insbesondere funktionellen Oberfläche verstanden werden, welche einen Teil einer insbesondere kapazitiven Sensorik bildet oder welche der weiteren Kontaktierung weiterer Vorrichtungen oder Bauelemente dienen.

Unter einem Kontakt-Pad kann ein elektrisch leitfähiger insbesondere metallischer Kontakt verstanden werden, mit dem ein oder mehrere Elektroden elektrisch kontaktierbar sind. Vorzugsweise weist das Kontakt-Pad im Vergleich zu einer Elektrode des Elektrodenarrays eine geringere Größe auf.

Unter einer ersten Schicht und/oder einer zweiten Schicht können insbesondere im Vergleich zu ihrer Fläche dünne Schichten, insbesondere flexible Folien, verstanden werden.

Die Elektrodenfläche kann hierbei auf der ersten Schicht aufgebracht sein. Die Elektrodenfläche kann alternativ oder zusätzlich in die erste Schicht eingebracht und/oder unterhalb der ersten Schicht angeordnet sein.

Das Kontakt-Pad kann hierbei oberhalb der zweiten Schicht angeordnet sein. Das Kontakt-Pad kann alternativ oder zusätzlich in die zweite Schicht eingearbeitet und/oder unterhalb der zweiten Schicht angeordnet sein.

### Vorteile der Erfindung

Indem die erste Schicht die wenigstens eine Elektrodenfläche umfasst und die zweite Schicht das wenigstens ein Kontakt-Pad umfasst, können die Funktionen des Elektrodenarrays auf den beiden unterschiedlichen Schichten getrennt voneinander optimiert werden. Somit kann die wenigstens eine Elektrodenfläche auf, in oder unterhalb der ersten Schicht möglichst flächenfüllend und/oder randnah, oder möglichst nah an einer bzw. mehreren weiteren Elektrodenflächen, die gemeinsam ein Elektrodenarray bilden, angeordnet werden, um eine zur Verfügung stehende Fläche auf der funktionellen Oberfläche möglichst effizient ausnutzen zu können. Abhängig von der Anordnung der Elektrodenfläche auf der ersten Schicht kann nun das Kontakt-Pad auf der zweiten Schicht entsprechend hinsichtlich seiner Größe dimensioniert und positioniert werden, so dass das Kontakt-Pad unterhalb der Elektrodenfläche angeordnet und von dieser, insbesondere vollständig überdenkt ist. Hierdurch kann eine Kontaktierung der Elektrodenfläche durch das Kontakt-Pad in besonders einfacher und sicherer Weise erreicht werden.

Weitere Vorteile ergeben sich aus den Unteransprüchen.

In einer bevorzugten Ausführungsform ist vorgesehen, dass das Kontakt-Pad und die Elektrodenfläche mittels eines leitfähigen Garns oder Fadens kontaktiert sind. Bevorzug ist hierbei das leitfähige Garn oder der leitfähige Faden sowohl durch das Kontakt-Pad als auch durch die Elektrodenfläche z.B. mittels eines Stickprozesses geführt, wodurch beide elektrisch miteinander kontaktiert sind. Hierdurch wird eine besonders einfache elektrische Kontaktierung der Elektrodenfläche erreicht, die sich insbesondere für flexible Oberflächen wie Textilien eignet.

In einer weiteren bevorzugten Ausführungsform kann vorgesehen sein, dass zwischen der ersten Schicht und der zweiten Schicht eine Isolationsschicht, insbesondere eine Folie aus isolierendem Kunststoff, angeordnet ist.

Die Isolationsschicht kann hierbei ebenfalls mit dem leitfähigen Garn oder Faden durchstochen sein. Hierdurch können ungewollte Kontaktierungen oder Kurzschlüsse zwischen der Elektrodenfläche, dem Kontakt-Pad und/oder weiteren elektrisch leitfähigen Materialien vermieden werden. Insbesondere kann im Falle von Elektrodenarrays mit einer Vielzahl an Elektrodenflächen, Kontakt-Pads und/oder Leiterbahnen dadurch gewährleistet werden, dass das Kontakt-Pad lediglich die oberhalb von dem Kontakt-Pad angeordnete Elektrodenfläche mit dem leitfähigen Garn oder Faden kontaktiert.

In einer weiteren bevorzugten Ausführungsform ist vorgesehen, dass die zweite Schicht wenigstens eine Leiterbahn aufweist, durch welche das Kontakt-Pad an eine, insbesondere externe, Energieversorgung und/oder eine, insbesondere externe, Auswerteelektronik anschließbar oder angeschlossen ist. Die Energieversorgung und/oder die Auswerteelektronik können sowohl auf der funktionellen Oberfläche angeordnet sein als auch extern angeordnet sein. Ferner können die Energieversorgung und/oder die Auswerteelektronik als, insbesondere flexible, Leiterplatte bzw. PCB (Englisch: Printed Circuit Board) ausgebildet sein. Die Leiterbahn kann hierbei auf der zweiten Schicht angeordnet, in die zweite Schicht eingearbeitet und/oder unterhalb der zweiten Schicht angeordnet sein. Die Leiterbahn kann bspw. als metallische Paste auch auf die zweite Schicht aufgedruckt bzw. aufgebracht oder als leitfähiges Garn oder, insbesondere metallischer, Faden in die zweite Schicht eingebracht oder an der zweiten Schicht angeordnet sein. Hierdurch ist das Elektrodenarray in besonders einfacher Weise energietechnisch und/oder signaltechnisch kontaktierbar.

Weiterhin ist es von Vorteil, wenn ein Flächeninhalt des Kontakt-Pads kleiner als der Flächeninhalt der Elektrodenfläche ist. Insbesondere ist es vorteilhaft, wenn der Flächeninhalt des Kontakt-Pads kleiner als 50 %, besonders bevorzugt kleiner als 25 % und ganz besonders bevorzugt kleiner als 10 % als der Flächeninhalt der Elektrodenfläche ist. Hierdurch wird einerseits Material des Kontakt-Pads eingespart, andererseits wird ein Freiheitsgrad, wie bspw. die Leiterbahn zwischen dem Kontakt-Pad und der Auswerteelektronik und/oder der Energieversorgung angeordnet werden kann, erhöht.

In einer weiteren bevorzugten Ausführungsform kann vorgesehen sein, dass die erste Schicht eine Mehrzahl an Elektrodenflächen aufweist und die zweite Schicht eine Mehrzahl an Kontakt-Pads aufweist, wobei die zweite Schicht unterhalb der ersten Schicht derart angeordnet ist, dass jede der Mehrzahl an Elektrodenflächen jeweils eines der Mehrzahl an Kontakt-Pads, insbesondere vollständig, überdeckt und mittels einer Durchkontaktierung durch dieses Kontakt-Pad elektrisch kontaktiert ist. Hierdurch wird in vorteilhafter Weise ein Elektrodenarray mit einer Vielzahl von Elektrodenflächen bereitgestellt, welches die zuvor bereits genannten Vorteile aufweist. Insbesondere zeichnet sich dieses Elektrodenarray dadurch aus, dass die Mehrzahl an Elektrodenflächen besonders nah aneinander angeordnet werden können und sich somit die nutzbare Fläche der funktionellen Oberfläche erhöht. Weiterhin ist dadurch gewährleistet, dass durch die unterhalb der Elektrodenflächen befindlichen Kontakt-Pads jede der Mehrzahl an Elektrodenflächen separat energietechnisch und/oder signaltechnisch kontaktierbar oder kontaktiert sind. Denn die Kontakt-Pads, welche auf die zweite Schicht angeordnet sind, sind derart an die Anordnung der Elektrodenflächen auf der ersten Schicht angepasst und in ihrer Größe dimensioniert, dass die Leiterbahnen zwischen den Kontakt-Pads und der Energieversorgung und/oder der Auswerteelektronik ohne störende Wechselwirkungen untereinander auf der zweiten Schicht angeordnet werden können.

Die zuvor genannten Vorteile gelten in entsprechender Weise auch für ein Verfahren zum Herstellen eines Elektrodenarrays, insbesondere gemäß einer der zuvor genannten Ausführungsformen. Das Verfahren weist einen Schritt des Bereitstellens einer ersten Schicht auf, wobei die erste Schicht wenigstens eine Elektrodenfläche umfasst. Weiterhin weist das Verfahren einen Schritt des Anordnens einer zweiten Schicht auf, welche wenigstens ein Kontakt-Pad umfasst. Die zweite Schicht wird hierbei derart unterhalb der ersten Schicht angeordnet, dass die Elektrodenfläche das Kontakt-Pads, insbesondere vollständig, überdeckt. Ferner weist das Verfahren einen Schritt des elektrischen Kontaktierens der Elektrodenfläche durch das Kontakt-Pad mittels einer Durchkontaktierung auf.

Indem die erste Schicht und die zweite Schicht unabhängig voneinander bereitgestellt bzw. angeordnet werden, kann zumindest die Anordnung der Elektrodenfläche auf der ersten Schicht weitestgehend unabhängig von der Anordnung des Kontakt-Pads bzw. von Leiterbahnen auf der zweiten Schicht erfolgen. Auch das Anordnen des Kontakt-Pads und/oder der Leiterbahnen auf der zweiten Schicht wird erleichtert, da auf keine eventuell vorhandenen, empfindlichen Elemente, wie bspw. Elektrodenflächen, Rücksicht genommen werden muss.

Es ist weiterhin von Vorteil, wenn im Schritt des Kontaktierens ein leitfähiges Garn oder ein leitfähiger Faden durch das Kontakt-Pad und die Elektrodenflächen gestochen wird. Hierdurch wird in besonders einfacher Weise die Elektrodenfläche mit dem Kontakt-Pad kontaktiert.

In einer bevorzugten Ausführungsform ist vorgesehen, dass im Schritt des Kontaktierens das Kontakt-Pad und die Elektrodenfläche mittels des leitfähigen Garns oder des leitfähigen Fadens miteinander verstickt und/oder vernäht werden. Hierdurch wird eine besonders robuste Kontaktierung zwischen dem Kontakt-Pad und der Elektrodenfläche erreicht. Insbesondere wird hierdurch auch die zweite Schicht mit der ersten Schicht mechanisch verbunden.

In einer weiteren Ausführungsform kann vorgesehen sein, dass vor dem Schritt des Anordnens der zweiten Schicht ein weiterer Schritt des Anordnens einer Isolationsschicht, insbesondere einer Folie aus isolierendem Kunststoff, unterhalb der ersten Schicht erfolgt. Hierdurch werden die Elektrodenfläche auf der ersten Schicht und das Kontakt-Pad auf der zweiten Schicht zunächst voneinander isoliert und die Elektrodenfläche und das Kontakt-Pad werden nur an den dafür vorgesehenen Stellen mittels der Durchkontaktierung bzw. mittels des leitfähigen Garns oder des leitfähigen Fadens miteinander elektrisch verbunden. Hierdurch wird die Gefahr von Kurzschlüssen oder ungewollten Kontaktierungen besonders effizient verhindert.

In einer weiteren Ausführungsform ist vorgesehen, dass vor und/oder nach dem Schritt des Anordnens der zweiten Schicht ein Schritt des Aufbringens wenigstens einer Leiterbahn auf die zweite Schicht erfolgt, durch welche das Kontakt-Pad an eine Energieversorgung und/oder eine Auswerteelektronik angeschlossen wird. Die Leiterbahn kann alternativ oder zusätzlich in die zweite Schicht eingearbeitet und/oder unterhalb der zweiten Schicht angeordnet sein. Die Leiterbahn kann bspw. als metallische Paste auch auf die zweite Schicht aufgedruckt bzw. aufgebracht oder als leitfähiges Garn oder, insbesondere metallischer, Faden in die zweite Schicht eingebracht oder an der zweiten Schicht angeordnet sein. Hierdurch kann das Kontakt-Pad und somit auch das Elektrodenarray in besonders einfacherweise energietechnisch und/oder signaltechnisch kontaktiert werden.

In einer weiteren Ausführungsform ist vorgesehen, dass im Schritt des Bereitstellens die erste Schicht eine Mehrzahl an Elektrodenflächen umfasst, wobei im Schritt des Anordnens der zweiten Schicht die zweite Schicht eine Mehrzahl an Kontaktpads umfasst, wobei die zweite Schicht unterhalb der ersten Schicht derart angeordnet ist, dass jede der Mehrzahl an Elektrodenflächen jeweils eines der Mehrzahl an Kontakt-Pads, insbesondere vollständig überdeckt und mittels einer Durchkontaktierung elektrisch kontaktiert wird. Hierdurch kann in besonders einfacher Weise ein großflächiges Elektrodenarray mit möglichst nah aneinander angrenzenden Elektrodenflächen hergestellt werden, wobei die einzelnen Elektrodenflächen hierbei vor ungewollten elektrischen Wechselwirkungen, insbesondere vor Kurzschlüssen, untereinander geschützt sind.

Weiterhin ist es vorteilhaft, wenn nach dem Schritt des Anordnens der zweiten Schicht oder nach dem Schritt des Kontaktierens ein Schritt des Fixierens, insbesondere durch Laminieren oder Vernähen, der Schichten miteinander erfolgt. Hierzu können die Schichten bspw. gemeinsam in einen Träger- oder einen Spannrahmen eingespannt werden und nachträglich miteinander laminiert und/oder vernäht werden. Hierdurch wird ein besonders robustes und mechanisch stabiles Elektrodenarray für funktionellen Oberflächen geschaffen.

### Kurze Beschreibung der Zeichnungen

Ausführungsformen der Erfindung sind in den Zeichnungen schematisch dargestellt und in der nachfolgenden Beschreibung näher erläutert. Für die in verschiedenen Figuren dargestellten und ähnlich wirkenden Elemente werden gleiche Bezugszeichen verwendet, wobei auf eine wiederholte Beschreibung der Elemente verzichtet wird.

Es zeigen:
Figur 1 eine schematische Darstellung einer ersten Schicht und einer zweiten Schicht eines Elektrodenarrays vor einer Zusammenführung gemäß einem Ausführungsbeispiel;
Figur 2 eine schematische Darstellung des Elektrodenarrays nach der Zusammenführung der ersten Schicht und der zweiten Schicht gemäß einem Ausführungsbeispiel;
Figur 3 eine schematische Darstellung der einzelnen Schichten des Elektrodenarrays vor einer elektrischen Kontaktierung; sowie
Figur 4 ein Ablaufdiagramm eines Verfahrens zum Herstellen eines Elektrodenarrays gemäß einem Ausführungsbeispiel.

Wie bereits vorstehend ausgeführt, wird mit der vorliegenden Erfindung ein Elektrodenarray für funktionelle Oberflächen, insbesondere für Textilien, und ein Verfahren zum Herstellen eines Elektrodenarrays beschrieben, wobei sich das Elektrodenarray durch einen besonders hohen Nutzungsgrad der zur Verfügung stehenden Fläche auszeichnet.

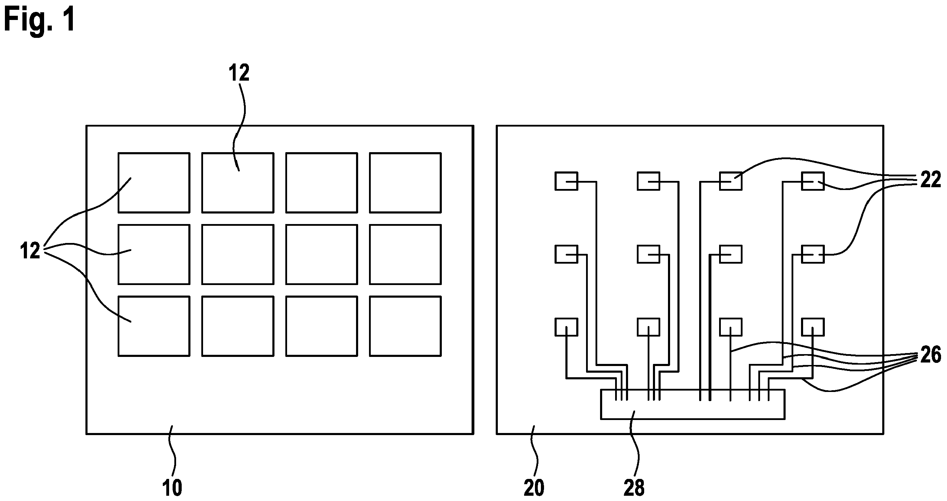

In Figur 1 sind eine erste Schicht 10 (linke Seite) und eine zweite Schicht 20 (rechte Seite) für ein Elektrodenarray 1 schematisch dargestellt. Die erste Schicht 10 und/oder die zweite Schicht 20 können hierbei flexibel ausgebildet sein. Insbesondere können die erste Schicht 10 und die zweite Schicht 20 eine Kunststofffolie oder ein Textil aufweisen. Auf der ersten Schicht 10 ist in diesem Ausführungsbeispiel eine Mehrzahl an Elektrodenflächen 12 angeordnet. Bei einer solchen Art der Anordnung spricht man auch von einem Array bzw. Feld. Die Elektrodenflächen 12 sind hierbei zeilenweise und spaltenweise auf der ersten Schicht 10 angeordnet. Die Elektrodenflächen 12 können hierbei in beliebiger Form, bspw. wie hier dargestellt in rechteckiger Form, alternativ z.B. in wabenförmiger Form oder sonstigen Geometrien vorliegen. Insbesondere sind die Elektrodenflächen 12 derart nebeneinander und untereinander angeordnet, dass zwischen den Elektrodenflächen 12 ein möglichst kleiner Abstand besteht. Ferner können die Elektrodenflächen 12 im Wesentlichen den gleichen Flächeninhalt aufweisen. Der Abstand sollte wenigstens so gewählt sein, dass sich benachbarte Elektrodenflächen 12 nicht gegenseitig kontaktieren bzw. kurzschließen.

Auf der zweiten Schicht 20 sind Kontakt-Pads 22 angeordnet. Die Anordnung der Kontakt-Pads 22 kann hierbei derjenigen Anordnung der Elektrodenflächen 12 im Wesentlichen entsprechen. Hierdurch ist gewährleistet, dass bei einer Anordnung der ersten Schicht 10 über der zweiten Schicht 20 jedes Kontakt-Pad 22, insbesondere vollständig, von einer Elektrodenfläche 12 überdeckt wird. Die Kontakt-Pads 22 weisen eine im Vergleich zu den Elektrodenflächen 12 deutlich geringere Fläche bzw. einen deutlich geringeren Flächeninhalt auf. Ferner können die Kontakt-Pads 22 im Wesentlichen den gleichen Flächeninhalt aufweisen. Hierdurch verbleibt auf der zweiten Schicht 20 genügend freie Fläche, um Leiterbahnen 26 zwischen den einzelnen Kontakt-Pads 22 und einer Energieversorgung und/oder Auswerteelektronik bzw. einer entsprechenden Schnittstelle 28 anzuordnen. Die Leiterbahnen 26 können aufgrund dieser zur Verfügung stehenden freien Fläche derart beabstandet voneinander angeordnet werden, dass keine Kurzschlüsse zwischen den Leiterbahnen 26 und/oder zwischen Leiterbahnen 26 und Kontakt-Pads 22 zu befürchten sind. Sowohl die Kontakt-Pads 22 als auch die Leiterbahnen 26 können oberhalb, innerhalb und/oder unterhalb der Schicht 20 angeordnet bzw. eingearbeitet oder integriert sein.

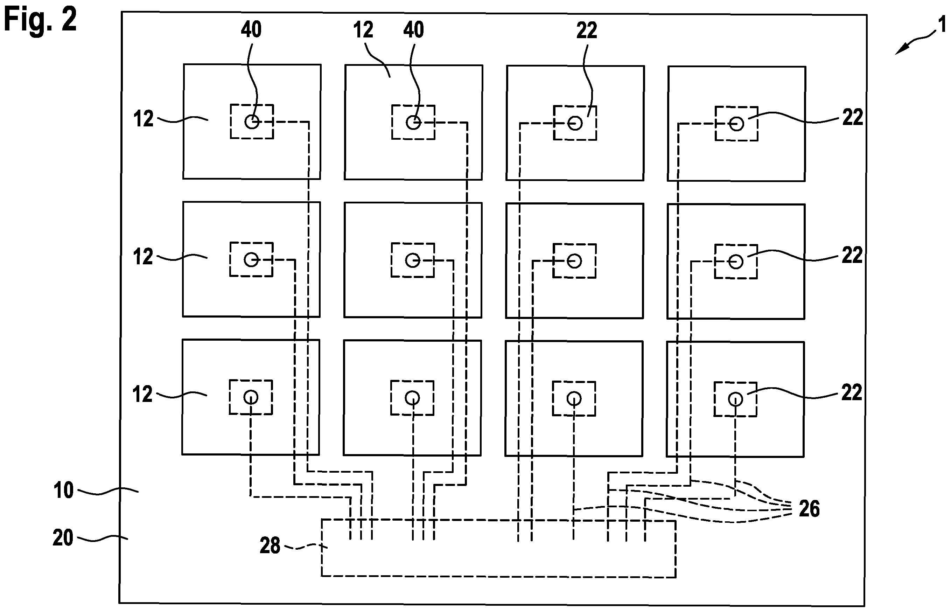

In Figur 2 ist eine schematische Darstellung eines Elektrodenarrays 1 in einer Draufsicht gezeigt. Hierbei ist die erste Schicht 10 über der zweiten Schicht 20 angeordnet. Die zweite Schicht 20 ist derart unterhalb der ersten Schicht 10 angeordnet, dass jedes der Mehrzahl an Kontakt-Pads 22 jeweils mittig unterhalb einer der Mehrzahl der Elektrodenflächen 12 positioniert ist. Gemäß diesem Ausführungsbeispiel sind die Elektrodenflächen 12 oberhalb der ersten Schicht 10 angeordnet und die Leiterbahnen 26 unterhalb der zweiten Schicht 20 angeordnet. Die Energieversorgung und/oder Auswerteelektronik und/oder Schnittstelle 28 ist hierbei ebenfalls unterhalb der zweiten Schicht 20 angeordnet. Jede der Elektrodenflächen 22 ist über eine Durchkontaktierung 40 mit jeweils einem, dem darunterliegenden Kontakt-Pad 22 elektrisch kontaktiert. Die erste Schicht 10 und die zweite Schicht 20 können hierbei partiell oder ganzflächig laminiert oder vernäht sein. Das Elektrodenarray 1 kann zur weiteren Verwendung in ein Textil integriert oder auf das Textil angeordnet werden.

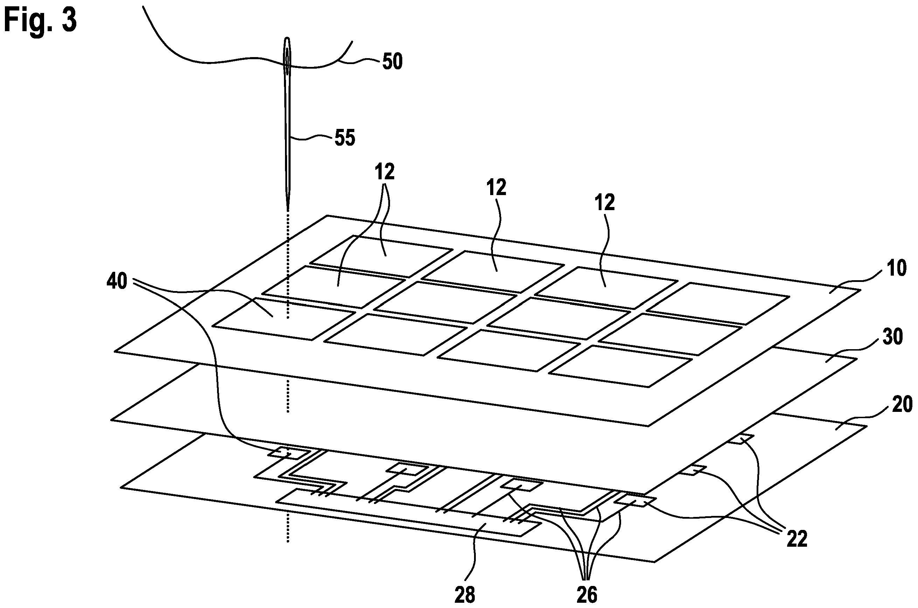

In Figur 3 ist ein Schichtaufbau des Elektrodenarray 1 perspektivisch dargestellt. Zwischen der ersten Schicht 10 und der zweiten Schicht 20 ist in diesem Ausführungsbeispiel eine zusätzliche, die erste Schicht 10 und die zweite Schicht 20 voneinander elektrisch isolierende Schicht 30 eingebracht bzw. angeordnet. Die Isolationsschicht 30 kann hierbei aus einem isolierenden Kunststoff gefertigt sein und ist flexibel ausgebildet. Entsprechend dem in Figur 2 beschriebenen Ausführungsbeispiel können die erste Schicht 10 und die zweite Schicht 20 mit der dazwischen befindlichen Isolationsschicht 30 übereinander angeordnet werden und wenigstens bereichsweise laminiert oder vernäht werden, so dass ein mechanisch stabiler Verbund aus den Schichten 10, 20, 30 entsteht.

Weiterhin ist eine Nadel 55 zusammen mit einem elektrisch leitfähigen Garn oder Faden 50 dargestellt, wobei die Nadel 55 die erste Schicht 10, die Isolationsschicht 30 und die zweite Schicht 20 durchsticht. Der Ort, an dem die Nadel 55 zusammen mit dem elektrisch leitfähigen Faden oder Garn 50 die Schichten durchsticht, entspricht der Stelle auf den Elektrodenflächen 12 bzw. den Kontakt-Pads 22, an denen beide miteinander elektrisch kontaktiert werden. Das elektrisch leitfähige Garn oder der elektrisch leitfähige Faden 50 übernimmt hierbei die Funktion der Durchkontaktierung 40. Hierbei wird jede Elektrodenfläche 12 mit jeweils dem darunterliegenden Kontakt-Pad 22 elektrisch kontaktiert. Diese elektrische Kontaktierung mittels des elektrisch leitfähigen Garns oder elektrisch leitfähigen Fadens 50 kann hierbei auch mehrfach erfolgen, in dem die jeweilige Elektrodenfläche 12 und das jeweils darunterliegende Kontakt-Pad 22 mehrfach mit der Nadel 55 samt dem elektrisch leitfähigen Garn oder dem elektrisch leitfähigen Faden 50 durchstochen werden. Insbesondere können die jeweilige Elektrodenfläche 12 und das darunterliegende Kontakt-Pad 22 mit dem elektrisch leitfähigen Garn 50 oder dem elektrisch leitfähigen Faden 50 miteinander verstickt und/oder vernäht werden. Hierdurch werden die einzelnen Schichten zusätzlich mechanisch miteinander fixiert.

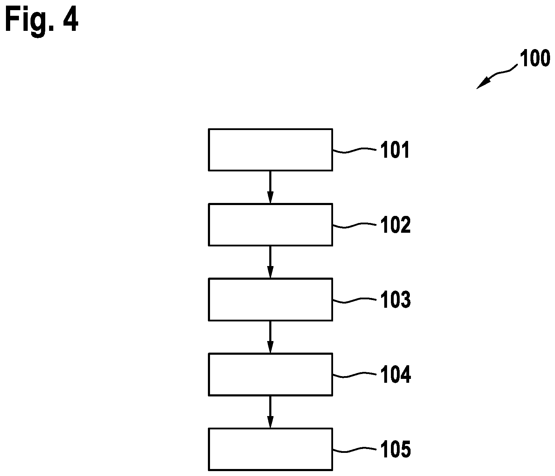

In Figur 4 ist ein Ablaufdiagramm eines Verfahrens 100 zum Herstellen eines Elektrodenarrays 1, insbesondere gemäß einer der zuvor beschriebenen Ausführungsformen, gezeigt. In einem ersten Schritt 101 erfolgt ein Bereitstellen einer ersten Schicht 10, welche wenigstens eine Elektronenfläche 12 umfasst. In einem optionalen zweiten Schritt 102 erfolgt ein Anordnen einer Isolationsschicht 30 unterhalb der ersten Schicht 10. In einem weiteren Schritt 103 erfolgt ein Anordnen einer zweiten Schicht 20 unterhalb der ersten Schicht 10 oder unterhalb der Isolationsschicht 30. Die zweite Schicht 20 wird derart unterhalb der ersten Schicht 10 oder der Isolationsschicht 30 angeordnet, dass die Elektrodenfläche 12 ein auf der zweiten Schicht 20 angeordnetes Kontakt-Pad 22, insbesondere vollständig, überdeckt. In einem weiteren Schritt 104 erfolgt ein elektrisches Kontaktieren der Elektrodenfläche 12 durch das Kontakt-Pad 22 mittels einer Durchkontaktierung 40. Optional kann ein weiterer Schritt 105 erfolgen, bei dem die erste Schicht 10, die zweite Schicht 20 oder die erste Schicht 10, die Isolationsschicht 30 und die zweite Schicht 20 miteinander fixiert werden. Der optionale Schritt 105 kann hierbei alternativ auch vor dem Schritt 104 des elektrischen Kontaktierens erfolgen.

In bzw. vor dem Schritt 103 des Anordnens der zweiten Schicht 20 können die Kontakt-Pads 20 und/oder die Leiterbahnen 26 bereits innerhalb der zweiten Schicht 20 integriert, und/oder oberhalb und/oder unterhalb der zweiten Schicht 20 angeordnet sein. Alternativ kann vorgesehen sein, dass die Kontakt-Pads 22 und/oder die Leiterbahnen 26 nach dem Schritt 104 des elektrischen Kontaktierens und/oder nach dem Schritt 105 des Fixierens der Schichten 10, 20, 30 aufgebracht werden.

Das Elektrodenarray 1 kann beispielsweise in einem kapazitiven Sensorelement, insbesondere in einer Sensorhaut für Roboter, eingesetzt werden. Ferner kann das Elektrodenarray 1 in funktionellen und/oder interaktiven Oberflächen, wie sie beispielsweise in Fahrzeuginnenräumen, im smart home, in Fußböden oder in Kleidungsstücken eingesetzt werden, verwendet werden. Insbesondere ist das Elektrodenarray 1 für einen Einsatz in großflächiger Sensorik auf flexiblen Substraten eingerichtet.

## Patentansprüche

1. Elektrodenarray (1) für funktionelle Oberflächen, insbesondere für Textilien, aufweisend eine erste Schicht (10) und eine zweite Schicht (20), **dadurch gekennzeichnet, dass** die erste Schicht (10) wenigstens eine Elektrodenfläche (12) umfasst und dass die zweite Schicht (20) wenigstens ein Kontakt-Pad (22) umfasst, wobei die zweite Schicht (20) unterhalb der ersten Schicht (10) derart angeordnet ist, dass die Elektrodenfläche (12) das Kontakt-Pad (22), insbesondere vollständig, überdeckt und wobei das Kontakt-Pad (22) die Elektrodenfläche (12) mittels einer Durchkontaktierung (40) elektrisch kontaktiert.

2. Elektrodenarray (1) nach Anspruch 1, **dadurch gekennzeichnet, dass** das Kontakt-Pad (22) und die Elektrodenfläche (12), insbesondere mittels eines durch das Kontakt-Pad (22) und die Elektrodenfläche (12) gestochenen, leitfähigen Garns oder Fadens (50) kontaktiert sind.

3. Elektrodenarray (1) nach Anspruch 1 oder 2, **dadurch gekennzeichnet, dass** zwischen der ersten Schicht (10) und der zweiten Schicht (20) eine Isolationsschicht (30), insbesondere eine Folie aus isolierendem Kunststoff oder andere geeignete flächige Isolatoren, angeordnet ist.

4. Elektrodenarray (1) nach einem der Ansprüche 1 bis 3, **dadurch gekennzeichnet, dass** die zweite Schicht (20) wenigstens eine Leiterbahn (26) aufweist, durch welche das Kontakt-Pad (22) an eine Energieversorgung und/oder eine Auswerteelektronik und/oder eine Schnittstelle (28) anschließbar oder angeschlossen ist.

5. Elektrodenarray (1) nach einem der vorhergehenden Ansprüche, **dadurch gekennzeichnet, dass** ein Flächeninhalt des Kontakt-Pads (22) kleiner, bevorzugt kleiner als 50 %, besonders bevorzugt kleiner als 25 % und ganz besonders bevorzugt kleiner als 10 %, als der Flächeninhalt der Elektrodenfläche (12) ist.

6. Elektrodenarray (1) nach einem der vorhergehenden Ansprüche, **dadurch gekennzeichnet, dass** die erste Schicht (10) eine Mehrzahl an Elektrodenflächen (22) aufweist und die zweite Schicht (20) eine Mehrzahl an Kontakt-Pads (22) aufweist, wobei die zweite Schicht (20) unterhalb der ersten Schicht (10) derart angeordnet ist, dass jede der Mehrzahl an Elektrodenflächen (12) jeweils eines der Mehrzahl an Kontakt-Pads (22), insbesondere vollständig, überdeckt und mittels einer Durchkontaktierung (40) elektrisch kontaktiert ist.

7. Verfahren (100) zum Herstellen eines Elektrodenarrays (1), insbesondere gemäß einem der vorhergehenden Ansprüche, mit den Schritten:
- Bereitstellen (101) einer ersten Schicht (10) umfassend wenigstens eine Elektrodenfläche (12);
- Anordnen (103) einer zweiten Schicht (20) umfassend wenigstens ein Kontakt-Pad (22) derart unterhalb der ersten Schicht (10), dass die Elektrodenfläche (12) das Kontakt-Pad (22), insbesondere vollständig, überdeckt; sowie
- Elektrisches Kontaktieren (104) der Elektrodenfläche (12) durch das Kontakt-Pad (22) mittels einer Durchkontaktierung (40).

8. Verfahren (100) nach Anspruch 7, **dadurch gekennzeichnet, dass** im Schritt des Kontaktierens (104) ein leifähiges Garn oder ein leitfähiger Faden (50) durch das Kontakt-Pad (22) und die Elektrodenfläche (12) gestochen wird.

9. Verfahren (100) nach Anspruch 7 oder 8, **dadurch gekennzeichnet, dass** im Schritt des Kontaktierens (104) das Kontakt-Pad (22) und die Elektrodenfläche (12) mittels des leifähigen Garns oder des leitfähigen Fadens (50) miteinander verstickt und/oder vernäht werden.

10. Verfahren (100) nach einem der Ansprüche 7 bis 9, **dadurch gekennzeichnet, dass** vor dem Schritt des Anordnens (103) der zweiten Schicht (20) ein weiterer Schritt des Anordnens (102) einer Isolationsschicht (30), insbesondere einer Folie aus isolierendem Kunststoff oder anderer geeigneter flächiger Isolatoren, unterhalb der ersten Schicht (10) erfolgt.

11. Verfahren (100) nach einem der Ansprüche 7 bis 10, **dadurch gekennzeichnet, dass** vor und/oder nach dem Schritt des Anordnens (103) der zweiten Schicht (20) ein Schritt des Aufbringens wenigstens einer Leiterbahn (26) auf die zweite Schicht (20), insbesondere auf eine Unterseite der zweiten Schicht (20), erfolgt, durch welche das Kontakt-Pad (22) an eine Energieversorgung und/oder eine Auswerteelektronik und/oder eine Schnittstelle (28) angeschlossen wird.

12. Verfahren (100) nach einem der Ansprüche 7 bis 11, **dadurch gekennzeichnet, dass** im Schritt des Bereitstellens (101) die erste Schicht (10) eine Mehrzahl an Elektrodenflächen (12) umfasst, wobei im Schritt des Anordnens (103) der zweiten Schicht (20) die zweite Schicht (20) eine Mehrzahl an Kontakt-Pads (22) umfasst, wobei die zweite Schicht (20) unterhalb der ersten Schicht (10) derart angeordnet ist, dass jede der Mehrzahl an Elektrodenflächen (12) jeweils eines der Mehrzahl an Kontakt-Pads (22), insbesondere vollständig, überdeckt und mittels einer Durchkontaktierung (40) elektrisch kontaktiert wird.

13. Verfahren (100) nach einem der Ansprüche 7 bis 12, **dadurch gekennzeichnet, dass** nach dem Schritt des Anordnens (103) der zweiten Schicht (20) oder nach dem Schritt des Kontaktierens (104) ein Schritt des Fixierens (105), insbesondere durch Laminieren oder Vernähen, der Schichten (10, 20, 30) miteinander erfolgt.
